Europäisches Patentamt

European Patent Office

Office européen des brevets

(19)

(11) Veröffentlichungsnummer: **0 133 656**
**A2**

(12) # EUROPÄISCHE PATENTANMELDUNG

(21) Anmeldenummer: **84108174.8**

(22) Anmeldetag: **12.07.84**

(51) Int. Cl.⁴: **G 06 K 7/08**

(30) Priorität: **11.08.83 FI 832885**

(43) Veröffentlichungstag der Anmeldung:
**06.03.85 Patentblatt 85/10**

(84) Benannte Vertragsstaaten:
**AT CH DE FR GB IT LI NL SE**

(71) Anmelder: **Aspo Oy**
**Olarinluoma 15**
**SF-02200 Espoo 20(FI)**

(72) Erfinder: **Korhonen, Jukka**
**Rasinrinne 3 - 5 B 33**
**SF-01360 Vantaa 36(FI)**

(72) Erfinder: **Viljanen, Teijo**
**Kromitie 7**
**SF-02760 Espoo 76(FI)**

(74) Vertreter: **Vollbach, Hans, Dipl.-Ing. et al,**
**Patentanwälte Dipl.-Ing. Buschhoff Dipl.Ing Hennicke**
**Dipl.-Ing. Vollbach Kaiser-Wilhelm-Ring 24**
**D-5000 Köln 1(DE)**

(54) Verfahren zum kapazitiven Lesen von Codekarten und Vorrichtung zur Durchführung eines solchen Verfahrens.

(57) Die Sendeelektroden (12a, 12b) einer Lesevorrichtung werden dazu verwendet, ein Hochfrequenzsignal $(f_1, \overline{f_1})$ über einen für eine Codekarte (1) vorgesehenen Schlitz an Empfangselektroden (12) auf der gegenüberliegenden Seite des Schlitzes zu übertragen, wobei das von den Empfangselektroden (12) empfangene Signal $(f_2)$ durch die Wirkung von Leitpunkten (2) auf der Codekarte (1) geändert wird. Hierbei soll eine größtmögliche Anzahl von Codekombinationen auf einer Codekarte (1) erreichbar sein und die Codekombination sollen durch Verwendung einer geringstmöglichen Anzahl von Sende-/Empfangselektrodenpaaren in der Lesevorrichtung sicher identifizierbar sein. Die Sendeelektroden (12a, 12b), die einander folgend in der Einschubrichtung der Codekarte (1) angeordnet sind, werden dazu verwendet, Signale $(f_1, \overline{f_1})$ mit zueinander unterschiedlichen Phasen auszusenden. Die Codekarte (1) trägt Leitpunkte (2), die bei Einschieben der Codekarte (1) zwischen die Elektroden die verschiedene Phasen aufweisenden Signale $(f_1, \overline{f_1})$ der Sendeelektroden (12, 12b) abwechselnd auf die Empfangselektrode (12) übertragen.

EP 0 133 656 A2

Die vorliegende Erfindung betrifft ein Verfahren zum kapazitiven Lesen von Codekarten, bei dem Sendeelektroden eines Lesers dazu verwendet werden, ein Hochfrequenzsignal über einen für eine Codekarte vorgesehenen Schlitz an Empfangselektroden auf der gegenüberliegenden Seite des Schlitzes zu übertragen, und bei dem sich das so empfangene Signal durch die Wirkung von Leitpunkten auf der Codekarte ändert. Die Erfindung betrifft auch eine Vorrichtung zum kapazitiven Lesen von Codekarten zur Durchführung des Verfahrens, mit einem Hochfrequenz-Generator, Sendeelektroden, Empfangselektroden gegenüber den Sendeelektroden und einem zwischen den Sendeelektroden und den Empfangselektroden vorgesehenen Schlitz zum Einschieben einer Codekarte, wobei die Sendeelektroden zum Senden eines Hochfrequenzsignals an den Generator angeschlossen sind und wobei ein kapazitiv zwischen den Elektroden übertragenes Signal durch die Wirkung von Leitpunkten auf der Codekarte änderbar ist.

Bei dieser Art von aus dem Stand der Technik bekannten Vorrichtungen zum Lesen von Codekarten wird die Identifizierung einer Codekarte erst dann durchgeführt, wenn die Codekarte vollständig in den Aufnahmeschlitz einer Lesevorrichtung eingeschoben worden ist und ihre statische Endstellung erreicht hat. Dieses Prinzip zum Lesen eines Codes beschränkt die Anzahl von möglichen Codekombinationen auf einer Codekarte auf eine relativ bescheidene Größe im Verhältnis zur Anzahl von Sende-/Empfangselektrodenpaaren einer Lesevorrichtung. Nun liegt es aber auf der Hand, daß eine größere Anzahl von Sende-/Empfangselektrodenpaaren den Preis einer solchen Vorrichtung ansteigen läßt. Ein weiterer Nachteil bei den aus dem Stand der Technik bekannten Vorrichtungen zum kapazitiven Lesen von Codekarten besteht darin, daß sie für Störungen recht empfindlich und daher unzuverlässig sind. Gleichwohl werden solche Vorrichtungen zum Lesen von Codekarten auch dort verwendet, wo eine besonders hohe Zuverlässigkeit gefordert ist und eine große Anzahl von Codekombinationen benötigt wird. Derartige Codekarten und entsprechende Lesevorrichtungen werden zunehmend gebräuchlich zum Betrieb einer Vielzahl von automatischen Vorrichtungen, beispielsweise zum Öffnen von Schlössern, in Kreditkartenautomaten beispielsweise in Servicestationen, in Bank-Kreditkarten beispielsweise für Geldautomaten usw.. Da es bislang nicht möglich gewesen ist, die zuvor erläuterten Nachteile bei Vorrichtungen zum kapazitiven Lesen von Codekarten auszuschalten, sind vorwiegend induktive und magnetische Vorrichtungen zum Lesen von Codekarten populär geworden.

Die Aufgabe der Erfindung besteht darin, ein neues und besseres Verfahren zum kapazitiven Lesen von Codekarten anzugeben, mit dem eine größtmögliche Anzahl von Codekombinationen auf einer Codekarte erreichbar ist und diese Codekombinationen durch Verwendung einer geringstmöglichen Anzahl von Sende-/Empfangselektrodenpaaren in der Lesevorrichtung sicher identifizierbar sind.

Das erfindungsgemäße Verfahren, bei dem die zuvor aufgezeigte Aufgabe gelöst ist, ist dadurch gekennzeichnet, daß von einander folgenden (zueinander benachbarten) Sendeelektroden unterschiedliche Signale gesendet werden, daß die Signale durch Einschieben der Codekarte zwischen die Elektroden mittels der Leitpunkte der Codekarte abwechselnd auf ein und dieselbe Empfangselektrode übertragen werden, daß ein bestimmtes charakteristisches Merkmal jedes von der Empfangselektrode empfangenen Signals, in dem sich die Signale der Sendeelektroden unterscheiden, im Verhältnis zu einem der Sendesignale überwacht wird und daß eine Änderung dieses überwachten charakteristischen Merkmals als auszulesender Leitpunkt der Codekarte gewährt wird.

Vorteilhafte Ausgestaltungen des erfindungsgemäßen Verfahrens sowie Merkmale einer erfindungsgemäßen Vorrichtung zur Durchführung eines solchen Verfahrens ergeben sich aus den Ansprüchen.

Im folgenden wird die Erfindung anhand einer lediglich ein Ausführungsbeispiel darstellenden Zeichnung näher erläutert; es zeigt

Fig. 1 in Draufsicht eine zu lesende Codekarte,

Fig. 2 in schematischer Darstellung die Verteilung kapazitiver Identifizierungs-Elektroden in einem Kartenleser,

Fig. 3 in schematischer Darstellung und im Schnitt die Elektroden zum Lesen eines Codes bei einer erfindungsgemäßen Lesevorrichtung,

Fig. 4 die Signale an verschiedenen Elektroden in Fig. 3,

Fig. 5 in schematischer Darstellung und im Schnitt die Konstruktion und relative Lage von Positionier-Elektroden einer erfindungsgemäßen Vorrichtung, außerdem verschiedene Vorverstärker in Verbindung mit einem Rechnerkern zur Verarbeitung der Signale und

Fig. 6 ein Diagramm, das eine Auslesezone A von Positionier-Elektroden sowie eine Auslesezone B von Elektroden zum Lesen des Codes im Verhältnis zu dem von einer Codekarte zurückgelegten Weg S erkennen läßt.

Ein Kartenleser dient dazu, eine aus Kunststoff bestehende Codekarte 1 zu lesen, die vorzugsweise dem "Servicestandard" mit den Maßen 86 mm • 54 mm entspricht. Die Codekarte 1 weist fünf Codezeilen auf, von denen eine zur Bestimmung der Stellung der Codekarte 1 relativ zu einem Leser 11 genutzt wird. Diese Zeile weist lediglich einen Leitpunkt 3 zur Positionierung auf. Die weiteren vier Zeilen weisen insgesamt 31 Leitpunkte 2 zur Bildung des Codes auf. Ein Code wird dadurch gebildet, daß eine bestimmte Anzahl von Leitpunkten 2 für den Code zu elektrisch leitenden Punkten ausgebildet werden. Es ist leicht verständlich, daß die im dargestellten Ausführungsbeispiel vorhandenen 31 Leitpunkte 2 in der Lage sind, eine enorme Anzahl von Codekombinationen zu verwirklichen. Die vordere Kante der Codekarte 1 weist eine Leerstelle 4 auf. Die rückwärtige Kante weist Leitpunkte 5 auf, um eine mögliche Fehlanordnung der Codekarte 1 anzeigen zu können.

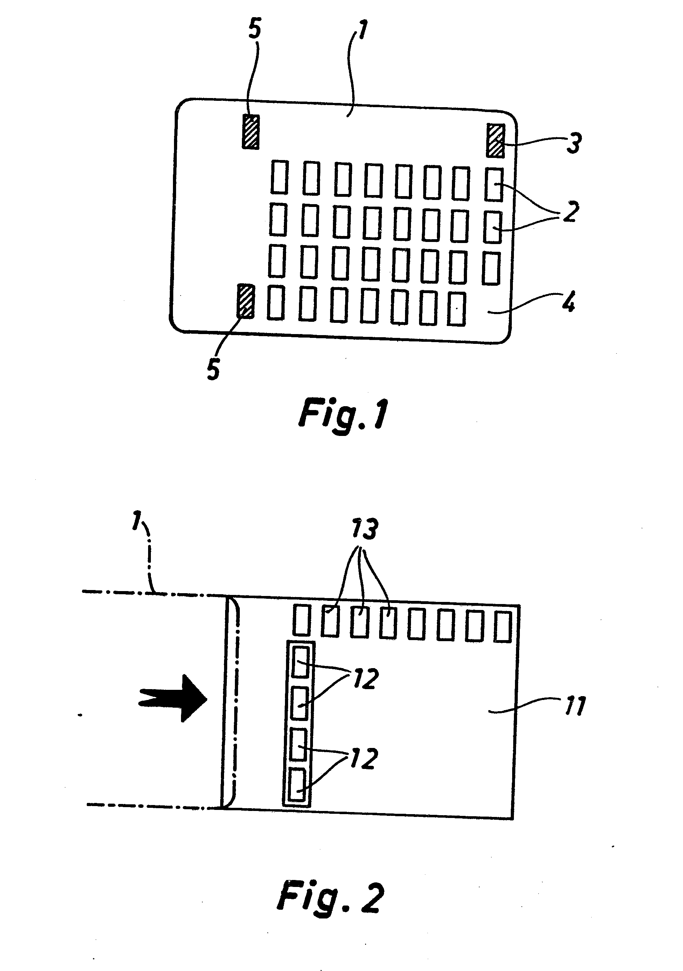

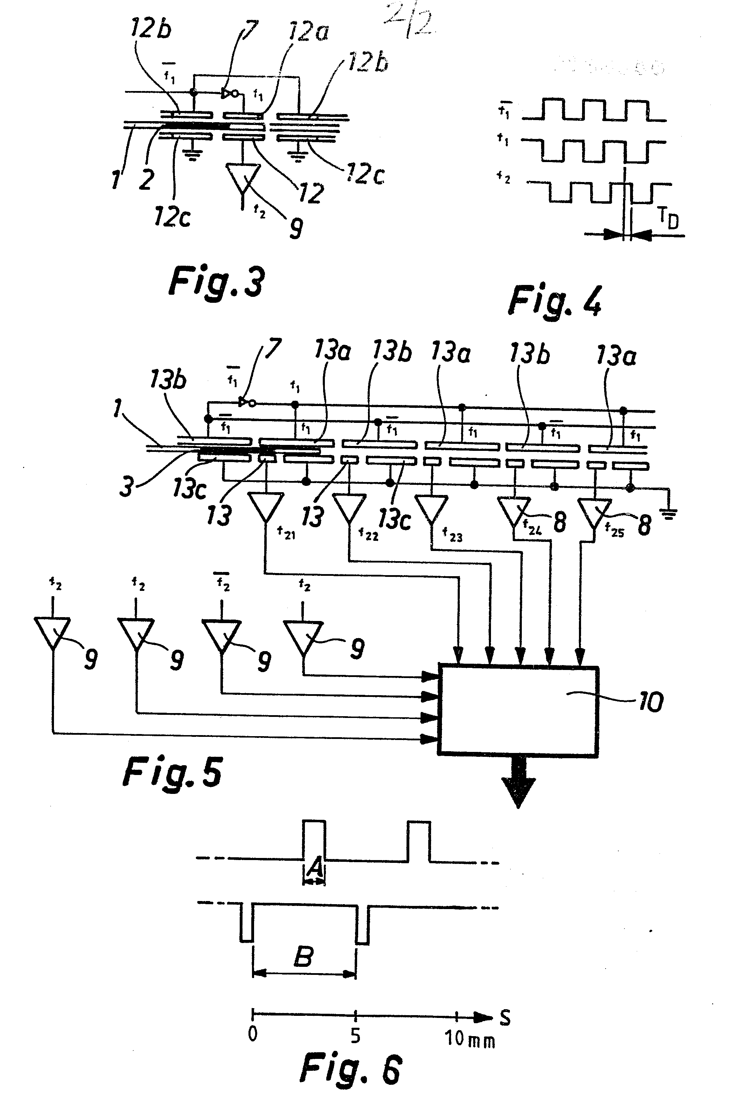

Fig. 2 zeigt, wie die Elektroden eines Lesers 11 angeordnet sein können. Die Stellung der Codekarte 1 relativ zu dem Leser 11 wird mittels 8 Paaren von Elektroden 13 gelesen, deren Konstruktion später in Verbindung mit Fig. 5 genauer erläutert werden wird. Die weiter vorgesehenen Elektroden 12 zum Lesen eines Codes sind nebeneinander in einer einzigen Spalte angeordnet, die sich quer zur Einschubrichtung der Codekarte 1 erstreckt. Die Anzahl von Elektroden 12 zum Lesen eines Codes ist vier in Übereinstimmung mit der Anzahl von Zeilen der Leitpunkte 2 zur Bildung des Codes.

Jeder elektrisch leitende Leitpunkt 2 auf der Codekarte 1 wird kapazitiv gelesen mittels eines Sensors, der in Fig. 3 dargestellt ist. Von einem Generator wird eine Spannung von ca. 5 V (Spitze/Spitze) bei einer Frequenz von etwa 500 kHz mit im wesentlichen rechteckiger Wellenform erzeugt. Diese Signale werden auf die Elektroden 12a, 12b auf der Sendeseite des Sensors gekoppelt. Eine Phasenumkehrstufe 7 dient dazu, die Phase des Signals $f_1$ an der Elektrode 12a im Vergleich mit der Phase des Signals $\overline{f_1}$ an der Elektrode 12b umzukehren (vgl. Fig. 4).

Ist kein leitender Leitpunkt 2 zwischen den Elektroden vorhanden, so wird das Signal $f_1$ kapazitiv auf die Empfangselektrode 12 übertragen. Ein von dieser Empfangselektrode 12 empfangenes Signal wird in einem Vorverstärker 9 od. dgl. auf das Spannungsniveau von 5 V verstärkt. Wegen der Anstiegszeit des Vorverstärkers 9 ist das so gewonnene Signal $f_2$ um eine geringe Verzögerungszeit $T_D$ gegenüber dem gesendeten Signal $f_1$ verzögert.

Wird in den Schlitz zwischen den Elektroden eine Codekarte 1 mit einem Leitpunkt 2 zum Lesen eines Codes eingeschoben, so findet sich der Leitpunkt 2 in einer Stellung, in der die Empfangselektrode 12 zum Teil oder vollständig von ihm abgedeckt ist. Dann ist die deckungsgleiche Fläche der Elektrode 12b und des Leitpunktes 2 größer als die deckungsgleiche Fläche des Leitpunktes 2 und der Elektrode 12a. Von der Elektrode 12b wird das Signal $\overline{f_1}$ auf den Leitpunkt 2 übertragen und von dort weiter auf die Empfangselektrode 12. Dadurch ist die Phase des Signals $f_2$ um etwa $180^{\circ}$ bezüglich der Phase des Signals $f_1$ verschoben. Die Feststellung des Leitpunktes 2 oder die Phasenumkehr des Signals $f_2$ wird dadurch angezeigt, daß aus dem Signal $f_2$ an der Anstiegsflanke des Signals $f_1$ Testwerte entnommen werden. Im Ergebnis ist dann, wenn ein Leitpunkt 2 vorliegt ein Ausgangswert "1", andernfalls "0".

Die Konstruktion der Elektroden, die für die Feststellung der Stellung der Codekarte 1 verwendet werden, ist geringfügig anders als die Konstruktion des Sensors zum Lesen des Codebereiches einer Codekarte 1. Aus der Querschnittsdarstellung in Fig. 5 ergibt sich, daß einander folgende Sendeelektroden 13a, 13b Signale mit wechselweise unterschiedlichen Phasen führen, da die Signale $f_1$ und $\overline{f_1}$ bei ihnen abwechseln. Ein Signal $\overline{f_1}$ vom Generator G wird mittels einer Phasenumkehrstufe 7 in ein Signal $f_1$ umgekehrt. Die Empfangselektroden 13 haben eine kleine Fläche und sind, in Einschubrichtung der Codekarte 1 gesehen, gegenüber der vorderen Kante der jeweiligen Sendeelektrode 13a, 13b angeordnet. Zwischen den Empfangselektroden 13 sind ferner Masseelektroden 13c vorgesehen. Wird nun eine Codekarte 1 in einen Schlitz zwischen den Elektroden eingeschoben, so erreicht ein Positionier-Leitpunkt 3 beispielsweise eine Elektrode 13, wodurch die Phase des empfangenen Signals $f_2$ umgekehrt wird. Diese Wirkung beruht darauf, daß die deckungsgleichen Bereiche des Leitpunktes 3 und der vorhergehenden Sendeelektrode 13b größer sind als die deckungsgleichen Bereiche des Leitpunktes 3 und einer Sendeelektrode 13a oberhalb und gegenüber der Empfangselektrode 13.

Die Phase des empfangenen Signals $f_2$ ändert sich wieder zurück, sobald der Leitpunkt 3 weiter unter die Sendeelektrode 13a oberhalb der Empfangselektrode 13 wandert.

Die Elektrodenanordnung führt zu einer Auslesezone A für Positionier-Leitpunkte 3, die schmaler ist als eine Auslesezone B für die Elektroden 12 zum Lesen des Codes (vgl. Fig. 6). Aus diesem Grunde ist es absolut sicher, daß dann, wenn ein Positionier-Leitpunkt 3 einer Codekarte 1 festgestellt wird, die möglichen Code-Leitpunkte 2 dieser speziellen Quer-Spalte mit Sicherheit festgestellt worden sind und daß die Daten, die den Code dieser Spalte kennzeichnen, beispielsweise "1 1 0 1", ungeachtet der Einschubgeschwindigkeit und der Einschubrichtung der Codekarte 1 korrekt sind. Ein praktisch vorkommender Bereich für die Einschubgeschwindigkeit der Codekarte 1 ist zwischen 0 und 50 m/s.

Die Vorverstärker 8 und 9 der Empfangselektroden 12, 13 können beispielsweise als nicht gepufferte Inverter in CMOS-Technik ausgeführt sein.

Ein Rechnerkern 10 für die Datensignale kann unter Verwendung von frei erhältlichen integrierten Schaltkreisen in für die Digitaltechnik üblicher Weise entworfen werden. Der Entwurf eines solchen Rechnerkerns 10 hängt vom jeweiligen Anwendungsfall ab.

Patentansprüche:

1. Verfahren zum kapazitiven Lesen von Codekarten, bei dem Sendeelektroden (12a, 12b; 13a, 13b) eines Lesers (11) dazu verwendet werden, ein Hochfrequenzsignal über einen für eine Codekarte (1) vorgesehenen Schlitz an Empfangselektroden (12; 13) auf der gegenüberliegenden Seite des Schlitzes zu übertragen, und bei dem sich das von den Empfangselektroden (12; 13) empfangene Signal durch die Wirkung von Leitpunkten (2; 3) auf der Codekarte (1) ändert, d a d u r c h   g e k e n n z e i c h n e t, daß von einander folgenden (zueinander benachbarten) Sendeelektroden (12a, 12b; 13a, 13b) unterschiedliche Signale ($f_1$, $\overline{f_1}$) gesendet werden, daß die Signale ($f_1$, $\overline{f_1}$) durch Einschieben der Codekarte (1) zwischen die Elektroden mittels der Leitpunkte (2; 3) der Codekarte (1) abwechselnd auf ein und dieselbe Empfangselektrode (12; 13) übertragen werden, daß ein bestimmtes charakteristisches Merkmal jedes von der Empfangselektrode (12; 13) empfangenen Signals ($f_2$), in dem sich die Signale ($f_1$, $\overline{f_1}$) der Sendeelektroden (12a, 12b; 13a, 13b) unterscheiden, im Verhältnis zu einem der Sendesignale ($f_1$ bzw. $\overline{f_1}$) überwacht wird und daß eine Änderung dieses überwachten charakteristischen Merkmals als auszulesender Leitpunkt (2; 3) der Codekarte (1) gewährt wird.

2. Verfahren nach Anspruch 1, dadurch gekennzeichnet, daß sich die wechselweise unterschiedlichen Signale ($f_1$, $\overline{f_1}$) in der Phase voneinander unterscheiden, daß die Phase des von der Empfangselektrode (12; 13) empfangenen Signals ($f_2$) im Verhältnis zur Phase eines der Sendesignale ($f_1$ bzw. $\overline{f_1}$) überwacht und eine Phasenumkehr als auszulesender Leitpunkt (2; 3) der Codekarte (1) gewertet wird.

3. Verfahren nach Anspruch 1 oder 2, dadurch gekennzeichnet, daß die Stellung der Codekarte (1) während des Einschiebens in den Leser (11) mehrmals festgestellt wird und daß die den Code bildenden Leitpunkte (2) der Codekarte (1) während jeder Feststellung der Stellung der Codekarte (1) in einer Spalte quer zur Einschubrichtung der Codekarte (1) gelesen werden.

4. Vorrichtung zum kapazitiven Lesen von Codekarten gemäß einem Verfahren nach einem der Ansprüche 1 bis 3, mit einem Hochfrequenz-Generator, mehreren Sendeelektroden (12a, 12b; 13a, 13b), Empfangselektroden (12; 13) gegenüber den Sendeelektroden (12a, 12b; 13a, 13b) und einem zwischen den Sendeelektroden (12a, 12b; 13a, 13b) und den Empfangselektroden (12; 13) vorgesehenen Schlitz zum Einschieben einer Codekarte (1), wobei die Sendeelektroden (12a, 12b; 13a, 13b) zum Senden eines Hochfrequenzsignals an den Generator angeschlossen sind und wobei ein kapazitiv zwischen den Elektroden übertragenes Signal durch die Wirkung von Leitpunkten (2; 3) auf der Codekarte (1) änderbar ist, d a d u r c h  g e k e n n z e i c h n e t, daß die Signale ($f_1$, $\overline{f_1}$) von einander folgenden (zueinander benachbarten) Sendeelektroden (12a, 12b; 13a, 13b) wechselseitig unterschiedlich sind und daß beim Einschieben der Codekarte (1) zwischen die Elektroden (12a, 12b; 13a, 13b bzw. 12; 13) mittels der Leitpunkte (2; 3) auf der Codekarte (1) die unterschiedlichen Signale ($f_1$ und $\overline{f_1}$) der Sendeelektroden (12a, 12b; 13a, 13b) abwechselnd auf die Empfangselektrode (12; 13) übertragbar sind.

5. Vorrichtung nach Anspruch 4, dadurch gekennzeichnet, daß eine Phasenumkehrstufe (7) vorgesehen ist und daß mittels der Phasenumkehrstufe (7) die Signale ($f_1$, $\overline{f_1}$) einander folgender (zueinander benachbarter) Sendeelektroden (12a, 12b; 13a, 13b) in gegenphasige Signale umsetzbar sind.

6. Vorrichtung nach Anspruch 4 oder 5, dadurch gekennzeichnet, daß ein Leser (11) in Einschubrichtung der Codekarte (1) mit einander folgenden Elektroden (13) versehen ist, mit deren Hilfe in Verbindung mit einem entsprechend an der vorderen Kante der Codekarte (1) angeordneten Positionier-Leitpunkt (3) die Stellung der Codekarte (1) feststellbar ist, daß der Leser (11) in einer Spalte quer zur Einschubrichtung der Codekarte (1) mit Elektroden (12) zum Lesen der den Code bildenden Leitpunkte (2) bei jeder Feststellung der Stellung der Codekarte (1) versehen ist.

7. Vorrichtung nach Anspruch 6, dadurch gekennzeichnet, daß die Flächengröße und die Relativlage der Elektroden so gewählt ist, daß eine Auslesezone (A) der Positionier-Elektroden (13) schmaler ist als eine Auslesezone (B) der Elektroden (12) zum Lesen des Codes.

8. Vorrichtung nach Anspruch 7, dadurch gekennzeichnet, daß die Empfangselektrode (12) einer Elektrode (12) zum Lesen des Codes einer mittleren Sendeelektrode (12a) gegenüber angeordnet ist und daß auf beiden Seiten der Sendeelektrode (12a) Sendeelektroden (12b) vorgesehen sind, deren Signale ($\overline{f_1}$) gegenphasig zum Signal ($f_1$) der mittleren Sendeelektrode (12a) verlaufen.

9. Vorrichtung nach Anspruch 7 oder 8, dadurch gekennzeichnet, daß die Empfangselektroden (13) der Positionier-Elektroden, deren Flächengröße erheblich kleiner ist als die Flächengröße der Sendeelektroden (13a, 13b), in Einschubrichtung der Codekarte (1) gesehen gegenüber dem Bereich der vorderen Kante jeder folgenden Sendeelektrode (13a, 13b, 13a .....) angeordnet ist.

**Fig.1**

**Fig. 2**

**Fig. 3**

**Fig. 4**

**Fig. 5**

**Fig. 6**